# EUROPEAN PATENT APPLICATION

(11) **EP 3 982 537 A1**
(43) Date of publication of application: **13.04.2022**
(21) Application number: 20819072.8
(22) Date of filing: 24.04.2020
(51) Int. Cl.: H03H 9/17

(54) **BULK ACOUSTIC RESONATOR WITH VARIABLE DOPING CONCENTRATION, FILTER, AND ELECTRONIC DEVICE**

(30) Priority: 06.06.2019 CN 201910493762
(71) Applicant: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/086552
(87) International publication number: WO 2020/244332

(57) **Abstract**

The present disclosure relates to a bulk acoustic resonator, comprising: a substrate; an acoustic mirror; a bottom electrode provided over the substrate; a top electrode provided oppositely to the bottom electrode and having an electrode connection portion; and a piezoelectric layer which is provided above the bottom electrode and between the bottom electrode and the top electrode, wherein the piezoelectric layer comprises at least three piezoelectric sub-layers, and the types of doped substances and/or the concentrations of the doped substances of the at least three piezoelectric sub-layers have alternate changes and/or periodic changes in the thickness direction of the piezoelectric layer. The present disclosure further relates to a filter having the bulk acoustic resonator, an electronic device having the filter, and a manufacturing method for the bulk acoustic resonator.

## Description

### TECHNICAL FIELD

Embodiments of the present disclosure relate to the field of semiconductors, and in particular, to a bulk acoustic wave resonator, a filter having the resonator, electronic equipment having the filter, and a method of manufacturing the bulk acoustic wave resonator.

### BACKGROUND

With the rapid development of wireless communication technology, there is an increasing demand for multi-passband transceivers that can simultaneously process large amounts of data. In recent years, the multi-passband transceivers have been widely used in the positioning system and the multi-standard system. These systems are required to simultaneously process signals in different frequency bands to improve the overall performance of the systems. Although the number of frequency bands in a single chip is increasing, the demands of consumers for miniaturized and multifunctional portable devices are increasing. The miniaturization has become the development trend of chips, which results in higher requirements for the sizes of filters.

In view of this, a film bulk acoustic resonator (Film Bulk Acoustic Resonator, referred to as FBAR) in the prior art has replaced the traditional waveguide technology to achieve a multi-band filter.

The FBAR mainly utilizes the piezoelectric effect and the inverse piezoelectric effect of the piezoelectric material to generate bulk acoustic waves, so as to form resonance in a device. The FBAR has inherent advantages such as high quality factor, large power capacity, high frequency (up to 2-10 GHz or even greater), and good compatibility with the standard integrated circuits (ICs). Accordingly, the FBAR can be widely applied in the radio frequency application systems with the higher frequency.

The structural main body of the FBAR is a "sandwich" structure composed of electrode-piezoelectric film-electrode. That is, a layer of piezoelectric material is sandwiched between two metal electrode layers. A sinusoidal signal is input between the two electrodes, such that the FBAR converts the input electrical signal into mechanical resonance by the inverse piezoelectric effect and then converts the mechanical resonance into an electrical signal for output by the piezoelectric effect. The FBAR mainly uses the longitudinal piezoelectric coefficient (d33) of the piezoelectric film to generate the piezoelectric effect, so that its main working mode is a thickness extensional mode (Thickness Extensional Mode, referred to as TE mode) in the thickness direction.

Ideally, the film bulk acoustic resonator only excites the (TE) mode in the thickness direction. However, when the bulk acoustic wave resonator is working, in addition to the (TE) mode in the thickness direction or a piston mode, the bulk acoustic wave resonator also generates waves in a lateral parasitic mode. For example, the waves in the Rayleigh-Lamb mode are mechanical waves perpendicular to the direction of the TE mode. These waves in the lateral mode will be reflected at the edge of the resonator to form reflected waves and interfere with incident waves, thereby forming standing waves in an effective excitation region of the resonator. Moreover, these waves in the lateral mode may be lost at the boundary of the resonator, thereby resulting in energy loss of the thickness extensional mode required by the resonator. The waves in the lateral parasitic mode eventually cause a decrease in the Q value of the resonator.

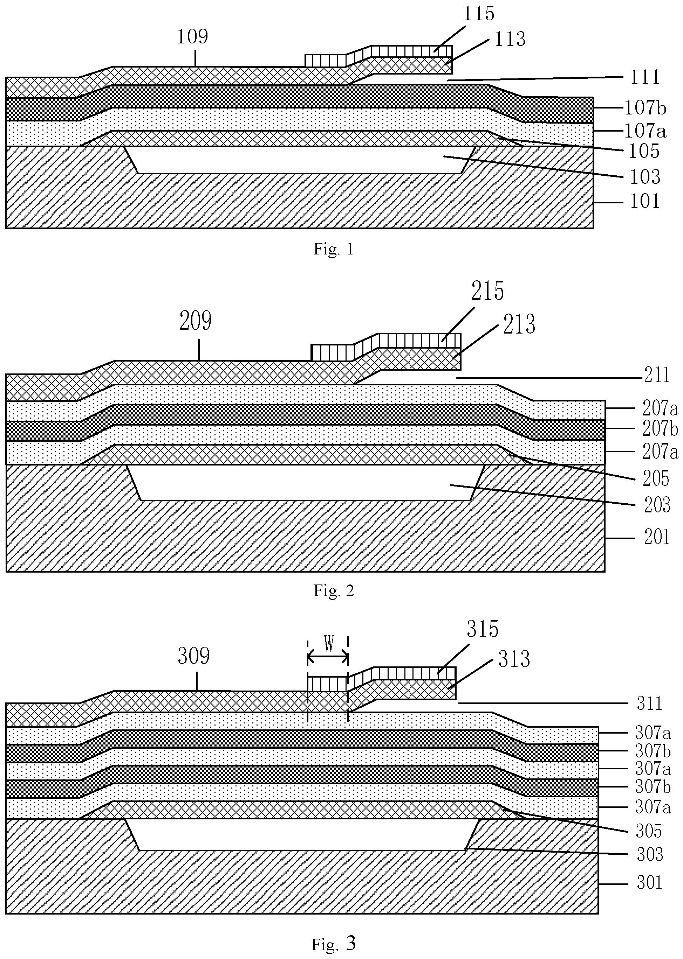

Abridge wing or bridge portion structure is formed by processing one or more edges of the electrode of the resonator. The bridge wing or bridge portion structure reflects the acoustic waves at the edge back into the resonator, and a part of the energy is simultaneously converted into a vibration mode in the vertical direction to improve the parallel resonance impedance Rp of the resonator. Hence, the Q value of the resonator is improved. Fig. 1 is a schematic sectional view of a film bulk acoustic resonator in the prior art. In Fig. 1, the bulk acoustic resonator includes a substrate 101, an acoustic mirror 103, a bottom electrode 105, a piezoelectric layer 107, and a top electrode 109. Furthermore, the top electrode 109 is further provided with a suspension wing structure 113 and a protrusion structure 115, and a gap 111 is provided between the suspension wing structure 113 and the piezoelectric layer 107.

In the prior art, as shown in Fig. 1, a solution of doping the piezoelectric layer, for example, forming a low doping layer and a high doping layer, is provided to improve the parallel resonance impedance Rp of the resonator. In Fig. 1, the piezoelectric layer 107 is divided into a low concentration doping sublayer 107a of ALN and a high concentration doping sublayer 107b of ALN.

However, there is still a need in practical applications to further improve the parallel resonance impedance Rp of the resonator, thereby increasing the Q value of the resonator.

Furthermore, in the technical solution of layered doping of the piezoelectric layer shown in Fig. 1, because of the different doping concentrations, adjacent interfaces are subjected to a greater stress due to different stresses on the sublayers of the upper and lower piezoelectric layers. Accordingly, the two sublayers are prone to being not tightly combined with each other, which further affects the performance of the resonator.

### SUMMARY

In order to alleviate or solve at least one aspect of the above problems in the prior art, the present disclosure is provided.

According to one aspect of embodiments of the present disclosure, a bulk acoustic wave resonator is provided and includes:
a substrate;
an acoustic mirror;
a bottom electrode provided above the substrate;
a top electrode arranged opposite to the bottom electrode and provided with an electrode connection portion; and
a piezoelectric layer provided above the bottom electrode and arranged between the bottom electrode and the top electrode,
wherein:
   the piezoelectric layer includes at least three piezoelectric sublayers, and types of doping substances of the at least three piezoelectric sublayers and/or doping concentrations of doping substances of the at least three piezoelectric sublayers alternately change and/or periodically change in a thickness direction of the piezoelectric layer.

Alternatively, the at least three piezoelectric sublayers are three adjacent piezoelectric sublayers.

Alternatively, the at least three piezoelectric sublayers are an odd number of at least three adjacent piezoelectric sub-layers or an even number of at least three adjacent piezoelectric sublayers.

Alternatively, the at least three piezoelectric sublayers include n piezoelectric sublayers, and n is an odd number not less than 3.

Alternatively, types of doping substances of the n piezoelectric sublayers and/or doping concentrations of doping substances of the n piezoelectric sublayers alternately change in the thickness direction of the piezoelectric layer; and the types of the doping substances of the n piezoelectric sublayers and/or the doping concentrations of the doping substances of the n piezoelectric sublayers are symmetrically distributed with respect to a (n+1)/2th piezoelectric sublayer of the n piezoelectric sublayers.

Alternatively, the at least three piezoelectric sublayers have a maximum of (n+1)/2 types and/or doping concentrations and a minimum of two types and/or doping concentrations of doping substances.

Alternatively, doping concentrations of doping substances of a first to a (n+1)/2th piezoelectric sublayers of the n piezoelectric sublayers gradually increase, and doping concentrations of doping substances of the (n+1)/2th to a nth piezoelectric sublayers of the n piezoelectric sublayers gradually decrease; or doping concentrations of doping substances of a first to a (n+1)/2th piezoelectric sublayers of the n piezoelectric sublayers gradually decrease, and doping concentrations of doping substances of the (n+1)/2th to a nth piezoelectric sub-layers of the n piezoelectric sublayers gradually increase.

Or alternatively, the at least three piezoelectric sublayers include m piezoelectric sublayers, and m is an even number not less than 4.

Alternatively, types of doping substances of the m piezoelectric sublayers and/or doping concentrations of doping substances of the m piezoelectric sublayers periodically change in the thickness direction of the piezoelectric layer.

Alternatively, a plurality of piezoelectric sublayers of the m piezoelectric sublayers constitutes doping substances of which types and/or doping concentrations change in a single period, the plurality of piezoelectric sublayers includes p piezoelectric sublayers, and p is a natural number not less than 2; and the at least three piezoelectric sublayers only have p types and/or p doping concentrations of doping substances.

Alternatively, a lowest doping concentration of the doping concentrations is zero.

Alternatively, the doping substances include rare earth elements, group II elements, group XII elements, group IV elements, or group V elements.

Alternatively, the doping concentrations are within a range of 0-40%, and further within a range of 0-20%.

Alternatively, the resonator further includes a protrusion structure provided on the top electrode, the protrusion structure is provided with a base protrusion portion covering the top electrode, a width of the base protrusion portion is within a range from 0.2 µm to 10 µm, and further within a range from 0.75 µm to 6 µm.

According to another aspect of embodiments of the present disclosure, a filter is provided, and the filter includes the above bulk acoustic wave resonator.

According to still another aspect of embodiments of the present disclosure, electronic equipment is provided, and the electronic equipment includes the above filter.

Embodiments of the present disclosure further relate to a method of manufacturing a bulk acoustic wave resonator. The resonator includes a piezoelectric layer, the piezoelectric layer includes at least three piezoelectric sublayers in a stacked arrangement, and the at least three piezoelectric sublayers include at least three doped piezoelectric sublayers, wherein the method includes the step of making types of doping substances of the at least three piezoelectric sublayers and/or concentrations of doping substances of the at least three piezoelectric sublayers to alternately change and/or periodically change in a thickness direction of the piezoelectric layer.

### BRIEF DESCRIPTION OF DRAWINGS

The following description and drawings can facilitate to understand these and other features and advantages in various embodiments disclosed in the present disclosure. The same reference signs in the figures always indicate the same components, wherein:
Fig. 1 is a schematic sectional view of a film bulk acoustic resonator in the prior art;
Fig. 2 is a schematic sectional view of a bulk acoustic wave resonator according to an exemplary embodiment of the present disclosure;
Fig. 3 is a schematic sectional view of a bulk acoustic wave resonator according to another exemplary embodiment of the present disclosure;
Fig. 4 is a simulation diagram showing a relationship between a width W of a base protrusion portion of a protrusion structure provided on a top electrode and a parallel resonance impedance Rp of the resonator in the case of different structures of Figs. 1-3; and
Fig. 5 is a schematic sectional view of a bulk acoustic wave resonator according to still another exemplary embodiment of the present disclosure.

### DESCRIPTION OF EMBODIMENTS

The technical solutions of the present disclosure will be further described below in detail through embodiments and in conjunction with the drawings. The following description of the embodiments of the present disclosure with reference to the drawings is intended to explain the general inventive concept of the present disclosure, and should not be construed as a limitation to the present disclosure.

Hereinafter, a bulk acoustic wave resonator according to embodiments of the present disclosure will be described with reference to Figs. 2-5.

Fig. 2 is a schematic sectional view of a bulk acoustic wave resonator according to an exemplary embodiment of the present disclosure.

As shown in Fig. 2, the bulk acoustic wave resonator includes a substrate 201, an acoustic mirror 203, a bottom electrode 205, a piezoelectric layer 207, and a top electrode 209. Furthermore, the top electrode 209 is further provided with a suspension wing structure 213 and a protrusion structure 215, and a gap 211 is provided between the suspension wing structure 213 and the piezoelectric layer 207.

Differing from Fig. 1, as shown in Fig. 2, the piezoelectric layer 207 includes three piezoelectric sublayers, which are piezoelectric sublayers 207a, 207b and 207a, respectively. The doping concentrations in the three sublayers may be low-high-low, or may be high-low-high. As shown in Fig. 2, the piezoelectric sublayers on the upper and lower sides of the middle piezoelectric sublayer 207b have the same doping concentration.

In Fig. 2, doping concentrations of the three piezoelectric sublayers are 5%, 10%, and 5%, respectively.

Fig. 3 is a schematic sectional view of a bulk acoustic wave resonator according to another exemplary embodiment of the present disclosure.

As shown in Fig. 3, the bulk acoustic wave resonator includes a substrate 301, an acoustic mirror 303, a bottom electrode 305, a piezoelectric layer 307, and a top electrode 309. Furthermore, the top electrode 309 is further provided with a suspension wing structure 313 and a protrusion structure 315, and a gap 311 is provided between the suspension wing structure 313 and the piezoelectric layer 307.

Differing from Fig. 1, in Fig. 3, the piezoelectric layer 307 includes five piezoelectric sublayers, which are the piezoelectric sublayers 307a, 307b, 307a, 307b, and 307a sequentially from top to bottom. The doping concentrations in the five sublayers may be low-high-low-high-low, or may be high-low-high-low-high. It can be understood that the piezoelectric sublayers with the same reference sign have the same doping concentration.

A width W of a base protrusion portion of a protrusion structure (the width of the protrusion structure is merely a width of a portion of the protrusion structure located on the top electrode) is shown in Fig. 3. The width W of the base protrusion portion is within a range from 0.2 µm to 10 µm, and further, within a range from 0.75 µm to 6 µm.

In Fig. 3, the doping concentrations of the five piezoelectric sublayers are 5%, 10%, 5%, 10%, and 5%, respectively.

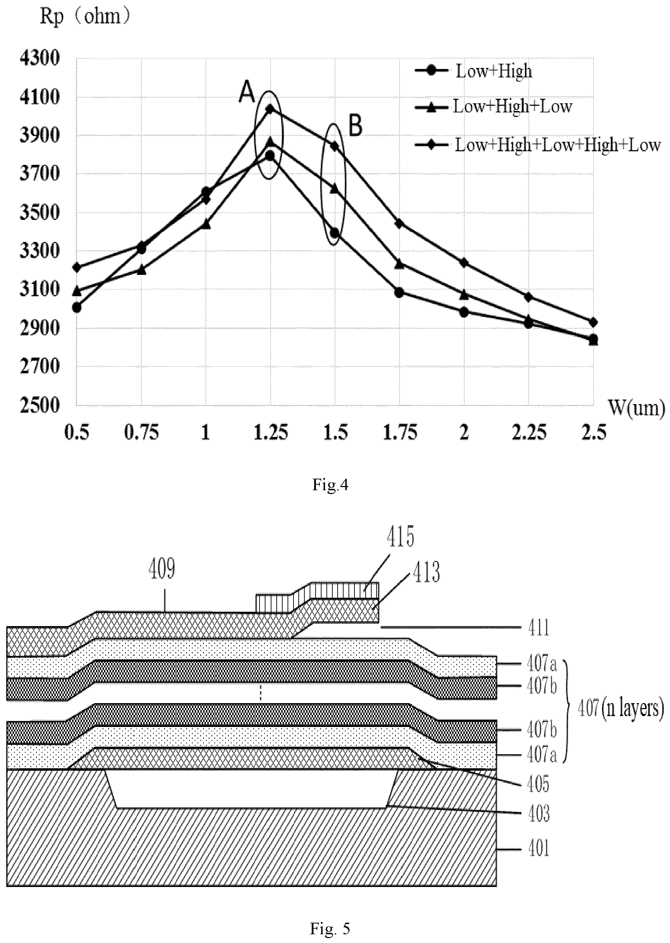

Fig. 4 is a simulation diagram showing a relationship between the width W of the base protrusion portion of the protrusion structure provided on the top electrode and a parallel resonance impedance Rp of the resonator in the case of different structures shown in Figs. 1-3. In the simulation of Fig. 4, a total thickness of the piezoelectric layer is constant, and the piezoelectric sublayers only have two doping concentrations, i.e., a high doping concentration and a low doping concentration.

As shown in Fig. 4, when W is within a range from 1.2 um to 2.5 um, the performance of the resonator in two cases of "low+high+low" and "low+high+low+high+low" is superior to the performance of the resonator in a case of "low+high". When W=1.25 um, Rp=4039.2 in the case of "low+high+low+high+low", which is increased by about 245.5 (about 6.5%) compared with Rp in the case of "low+high". When W=1.5 um, Rp=3845.3 in the case of "low+high+low+high+low", which is increased by about 448.7 (about 13.2%) compared with Rp in the case of "low+high".

In the above embodiments of the present disclosure, the case where the doping concentrations of the piezoelectric sublayers alternate in a form of high-low or low-high is described, but for the low-high alternating arrangement, the present disclosure is not limited thereto. In the present disclosure, the doping concentrations may be low-high alternating arrangement in even layers, or low-high alternating arrangement in odd layers.

In addition to the low-high alternating arrangement, in the present disclosure, the doping concentrations may gradually decrease and then gradually increase, or the doping concentrations may gradually increase and then gradually decrease. Further, the doping concentrations may periodically change in high and low forms.

Fig. 5 is a schematic sectional view of a bulk acoustic wave resonator according to still another exemplary embodiment of the present disclosure.

As shown in Fig. 5, the bulk acoustic wave resonator includes a substrate 501, an acoustic mirror 503, a bottom electrode 505, a piezoelectric layer 507, and a top electrode 509. Furthermore, the top electrode 509 is further provided with a suspension wing structure 513 and a protrusion structure 515, and a gap 511 is provided between the suspension wing structure 513 and the piezoelectric layer 507.

As shown in Fig. 5, the piezoelectric layer 507 is divided into n piezoelectric sublayers. In the embodiment of Fig. 5, the doping concentrations of the piezoelectric sublayers increase sequentially and then decrease sequentially in a top to bottom direction. Of course, it should be understood that the doping concentrations of the piezoelectric sublayers may decrease sequentially and then increase sequentially.

The doping substances may be rare earth elements. Alternatively, the doping substances are one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium, and lutetium.

The doping substances may be II/XII group elements (Ca, Mg, Sr, Zn, and the like), and IV/V group elements (Ti, Zr, Hf, and the like).

Alternatively, the material of the piezoelectric sublayers may be aluminum nitride or doped aluminum nitride.

In the present disclosure, different piezoelectric sublayers may use the same doping substance, or may use different doping substances.

It should be noted that, in the embodiments of the present disclosure, although the film bulk acoustic resonator is described as an example, these descriptions are applicable to other types of bulk acoustic wave resonators.

It should also be noted that the low doping concentration includes a zero doping concentration. In an embodiment, 0 represents an undoped piezoelectric sublayer, 1 represents a piezoelectric sublayer doped at an intermediate concentration, and 2 represents a piezoelectric sublayer doped at a high concentration. In this embodiment of the present disclosure, in the thickness direction of the piezoelectric layer, the piezoelectric layer may include the following exemplary structures:
010 (020, 121, 101, 202, 212), which correspond to the alternating change and are symmetrically distributed with respect to the central layer;
0101 (0202, 1212, 1010, 2020, 2121), which correspond to the periodic change, and each cycle contains two piezoelectric sublayers;
01210 (10201, 12021, 21012, 02120, 20102), which correspond to the alternating change and are symmetrically distributed with respect to the central layer; and
012012 (021021, 120120, 102102, 210210, 201201), which correspond to the periodic change, and each cycle contains three piezoelectric sublayers.

It should also be noted that, in addition to the concentrations of the doping substances described in the above embodiments, the alternating change and the periodic change of the piezoelectric sublayers may be different doping substances. If the doping substances include A, B, C, etc., the above concentration changes may be employed.

In view of the above description, the present disclosure provides the following technical solutions:
1. A bulk acoustic wave resonator including:
   a substrate;
   an acoustic mirror;
   a bottom electrode provided above the substrate;
   a top electrode arranged opposite to the bottom electrode and provided with an electrode connection portion; and
   a piezoelectric layer provided above the bottom electrode and arranged between the bottom electrode and the top electrode,
   wherein:
      the piezoelectric layer includes at least three piezoelectric sublayers, and types of doping substances of the at least three piezoelectric sublayers and/or doping concentrations of doping substances of the at least three piezoelectric sublayers alternately change and/or periodically change in a thickness direction of the piezoelectric layer.
2. The resonator according to 1, wherein:
   the at least three piezoelectric sublayers are three adjacent piezoelectric sub-layers.
3. The resonator according to 1, wherein:
   the at least three piezoelectric sublayers are an even number of at least three adjacent piezoelectric sublayers or an odd number of at least three adjacent piezoelectric sublayers.
4. The resonator according to 1, wherein:
   the at least three piezoelectric sublayers include n piezoelectric sublayers, and n is an odd number not less than 3.
5. The resonator according to 4, wherein:
   types of doping substances of the n piezoelectric sublayers and/or doping concentrations of doping substances of the n piezoelectric sublayers alternately change in the thickness direction of the piezoelectric layer; and
   the types of the doping substances of the n piezoelectric sublayers and/or the doping concentrations of the doping substances of the n piezoelectric sublayers are symmetrically distributed with respect to a (n+1)/2th piezoelectric sublayer of the n piezoelectric sublayers.
6. The resonator according to 5, wherein:
   the at least three piezoelectric sublayers have a maximum of (n+1)/2 types and/or doping concentrations and a minimum of two types and/or doping concentrations of doping substances.
7. The resonator according to 6, wherein:
   a lowest doping concentration of the doping concentrations is zero.
8. The resonator according to 7, wherein:
   doping concentrations of doping substances of a first to a (n+1)/2th piezoelectric sublayers of the n piezoelectric sublayers gradually increase, and doping concentrations of doping substances of a (n+1)/2th to a nth piezoelectric sublayers of the n piezoelectric sublayers gradually decrease; or
   doping concentrations of doping substances of a first to a (n+1)/2th piezoelectric sublayers of the n piezoelectric sublayers gradually decrease, and doping concentrations of doping substances of a (n+1)/2th to a nth piezoelectric sublayers of the n piezoelectric sublayers gradually increase.
9. The resonator according to 1, wherein:
   the at least three piezoelectric sublayers include m piezoelectric sublayers, and m is an even number not less than 4.
10. The resonator according to 9, wherein:
   types of doping substances of the m piezoelectric sublayers and/or doping concentrations of doping substances of the m piezoelectric sublayers periodically change in the thickness direction of the piezoelectric layer.
11. The resonator according to 10, wherein:
   a plurality of piezoelectric sublayers of the m piezoelectric sublayers constitutes doping substances of which types and/or doping concentrations change in a single period, the plurality of piezoelectric sublayers includes p piezoelectric sublayers, and p is a natural number not less than 2; and
   the at least three piezoelectric sublayers only have p types and/or p doping concentrations of doping substances.
12. The resonator according to 11, wherein:
   a lowest doping concentration of the doping concentrations is zero.

Based on the technical solutions of the present disclosure, the stress on a single adjacent interface is dispersed to a plurality of adjacent interfaces due to the alternately doping, thereby improving the adhesion between the films. Meanwhile, the stresses of the piezoelectric sublayers with different doping concentrations are different. For example, a stress value of one of the piezoelectric sublayers with a doping concentration is a negative value, and a stress value of another one of the piezoelectric sublayers with another doping concentration is a positive value. In this way, the stress interaction between the two piezoelectric sublayers can improve the overall stress distribution condition of the piezoelectric layer.

In addition, based on the technical solutions of the present disclosure, the parallel resonance impedance Rp of the resonator can be improved due to the alternately doping, for example, see Fig. 4.

Correspondingly, embodiments of the present disclosure further provide a method of manufacturing a bulk acoustic wave resonator. The resonator includes a piezoelectric layer, and the piezoelectric layer includes at least three piezoelectric sublayers in a stacked arrangement. The at least three piezoelectric sublayers include at least three doped piezoelectric sublayers. The method includes the steps of making the piezoelectric layer to include at least three piezoelectric sublayers, and making types of doping substances and/or doping concentrations of doping substances of the at least three piezoelectric sublayers to alternately change and/or periodically change in the thickness direction of the piezoelectric layer. Based on the steps of the method, the stress distribution in the piezoelectric layer of the resonator is improved.

Based on the above description, the present disclosure further provides a filter including a plurality of the above bulk acoustic wave resonators. The present disclosure further provides electronic equipment including the above filter or the above bulk acoustic wave resonator.

Although the embodiments of the present disclosure have been shown and described, it can be understood for those skilled in the art that modifications can be made to these embodiments without departing from the principle and spirit of the present disclosure, and the scope of the present disclosure is defined by the appended claims and their equivalents.

## Claims

1. A bulk acoustic wave resonator, comprising:
a substrate;
an acoustic mirror;
a bottom electrode provided above the substrate;
a top electrode arranged opposite to the bottom electrode and provided with an electrode connection portion; and
a piezoelectric layer provided above the bottom electrode and arranged between the bottom electrode and the top electrode,
wherein the piezoelectric layer comprises at least three piezoelectric sublayers, and types of doping substances of the at least three piezoelectric sublayers and/or doping concentrations of doping substances of the at least three piezoelectric sublayers alternately change and/or periodically change in a thickness direction of the piezoelectric layer.

2. The resonator according to claim 1, wherein the at least three piezoelectric sublayers are three adjacent piezoelectric sublayers.

3. The resonator according to claim 1, wherein the at least three piezoelectric sublayers are an odd number of at least three adjacent piezoelectric sublayers or an even number of at least three adjacent piezoelectric sublayers.

4. The resonator according to claim 1, wherein the at least three piezoelectric sublayers comprise n piezoelectric sublayers, and n is an odd number not less than 3.

5. The resonator according to claim 4, wherein types of doping substances of the n piezoelectric sublayers and/or doping concentrations of doping substances of the n piezoelectric sublayers alternately change in the thickness direction of the piezoelectric layer; and
the types of the doping substances of the n piezoelectric sublayers and/or the doping concentrations of the doping substances of the n piezoelectric sublayers are symmetrically distributed with respect to a (n+1)/2th piezoelectric sublayer of the n piezoelectric sublayers.

6. The resonator according to claim 5, wherein the at least three piezoelectric sublayers have a maximum of (n+1)/2 types and/or doping concentrations and a minimum of two types and/or doping concentrations of doping substances.

7. The resonator according to claim 6, wherein a lowest doping concentration of the doping concentrations is zero.

8. The resonator according to claim 7, wherein doping concentrations of doping substances of a first to a (n+1)/2th piezoelectric sublayers of the n piezoelectric sublayers gradually increase, and doping concentrations of doping substances of the (n+1)/2th to a nth piezoelectric sublayers of the n piezoelectric sublayers gradually decrease; or
doping concentrations of doping substances of a first to a (n+1)/2th piezoelectric sublayers of the n piezoelectric sublayers gradually decrease, and doping concentrations of doping substances of the (n+1)/2th to a nth piezoelectric sublayers of the n piezoelectric sublayers gradually increase.

9. The resonator according to claim 1, wherein the at least three piezoelectric sublayers comprise m piezoelectric sublayers, and m is an even number not less than 4.

10. The resonator according to claim 9, wherein types of doping substances of the m piezoelectric sublayers and/or doping concentrations of doping substances of the m piezoelectric sublayers periodically change in the thickness direction of the piezoelectric layer.

11. The resonator according to claim 10, wherein a plurality of piezoelectric sublayers of the m piezoelectric sublayers constitutes doping substances of which types and/or doping concentrations change in a single period, the plurality of piezoelectric sublayers comprises p piezoelectric sublayers, and p is a natural number not less than 2; and
the at least three piezoelectric sublayers only have p types and/or p doping concentrations of doping substances.

12. The resonator according to claim 11, wherein a lowest doping concentration of the doping concentrations is zero.

13. The resonator according to any one of claims 1-12, wherein materials of the piezoelectric sublayers are aluminum nitride or doped aluminum nitride.

14. The resonator according to any one of claims 1-13, wherein the types of the doping substances comprise rare earth elements, group II elements, group XII elements, group IV elements, or group V elements.

15. The resonator according to any one of claims 1-14, wherein the doping concentrations of the doping substances are within a range of 0-40%, and further within a range of 0-20%.

16. The resonator according to any one of claims 1-15, further comprising:
a protrusion structure provided on the top electrode, the protrusion structure being provided with a base protrusion portion covering the top electrode, a width of the base protrusion portion being within a range from 0.2 µm to 10 µm, and further within a range from 0.75 µm to 6 µm.

17. A filter, comprising the bulk acoustic wave resonator according to any one of claims 1-16.

18. An electronic equipment, comprising the filter according to claim 179 or the bulk acoustic wave resonator according to any one of claims 1-18.

19. A method of manufacturing a bulk acoustic wave resonator, the resonator comprising a piezoelectric layer, the piezoelectric layer comprising at least three piezoelectric sublayers in a stacked arrangement, and the at least three piezoelectric sublayers comprising at least three doped piezoelectric sublayers, wherein the method comprises the step of:
making types of doping substances of the at least three piezoelectric sublayers and/or concentrations of doping substances of the at least three piezoelectric sublayers to alternately change and/or periodically change in a thickness direction of the piezoelectric layer.
